# EUROPEAN PATENT APPLICATION

(11) **EP 0 704 906 A2**
(43) Date of publication of application: **03.04.1996**
(21) Application number: 95113928.6
(22) Date of filing: 05.09.1995
(51) Int. Cl.: H01L 29/423, H01L 29/47, H01L 21/28

(54) **Electrode of semiconductor device and method of fabricating thereof**

(30) Priority: 22.09.1994 JP 227735/94
(71) Applicant: MITSUBISHI DENKI KABUSHIKI KAISHA, Tokyo 100 (JP)
(72) Inventor: Noda, Minoru, c/o Mitsubishi Denki K.K., 1 Mizuhara 4-chome, Itami-shi, Hyogo 664 (JP)
(74) Representative: KUHNEN, WACKER & PARTNER

(57) **Abstract**

An electrode of a semiconductor device includes a semiconductor layer (6) having a surface, a laminated structure laminating a plurality of layers comprising conductive materials on the surface of the semiconductor layer (6) and having a side surface, and a side barrier layer disposed on the side surface of the laminated structure and comprising a conductive material which can prevent a conductive material of a specific layer constituting the laminated structure except a lowermost layer in contact with the semiconductor layer (6) reacting with the semiconductor layer (6) from diffusing into the semiconductor layer (6) through the side surface of the laminated structure. Therefore, the side barrier layer prevents the conductive material reacting with the semiconductor layer (6) from diffusing into the semiconductor layer (6) through the side surface of the laminated structure, and erosion of the semiconductor layer (6) and deterioration of a contact between the electrode (4) and the semiconductor layer (6) are not caused due to the reaction of the semiconductor layer (6) with the conductive material, whereby the reliability of the semiconductor device in which this electrode (4) is provided is improved.

## Description

### FIELD OF THE INVENTION

The present invention relates to an electrode of a semiconductor device and a fabricating method thereof and, more particularly, to a gate electrode of a field effect transistor and a fabricating method thereof.

### BACKGROUND OF THE INVENTION

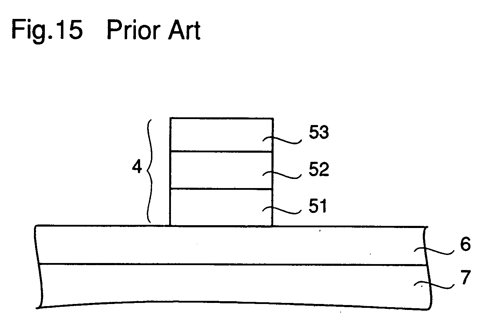

An electrode comprising Ti/Pt/Au, Ti/Mo/Au or the like is often used for a metal gate electrode of a GaAs field effect transistor (hereinafter referred to as a GaAs FET). Figure 15 is a cross-sectional view illustrating a conventional gate electrode of a GaAs FET. In the figure, reference numeral 7 designates a GaAs substrate. An n type GaAs layer 6 serves as an operating layer of the FET. A gate electrode 4 comprises a Ti layer 51, a Pt layer or Mo layer 52, and an Au layer 53.

A description is given of the operation.

The Ti layer 51 to be the lowermost layer of the gate electrode 4 makes a good Schottky contact with the n type GaAs layer 6. In order to improve a high frequency characteristic of the GaAs FET, the lower resistance of the gate electrode is required. Therefore, Au which normally has low resistance is often used as an upper metal of the gate electrode and disposed on the Ti layer.

However, since Au is diffusive, when the gate electrode comprises only Ti/Au, Au diffuses into the GaAs layer through the Ti layer. Further, Au makes contact with GaAs to react on it. In particular, a portion of the n type GaAs layer just below the gate electrode where this reaction is caused does not serve as a channel layer. More specifically, Au erodes the channel layer. This is called a gate sinking. In addition, this reaction causes such as a deterioration of a Schottky contact between the gate electrode and the GaAs layer, a lowering of a barrier potential, and an increase in a leakage current.

In order to prevent this diffusion of Au, a layer comprising a barrier metal, such as Pt and Mo, whose particles are fine is generally inserted between the Ti layer and the Au layer of the gate electrode as shown in figure 15.

In the conventional gate electrode structure shown in figure 15, the Pt layer or Mo layer preventing the diffusion of Au exists between the Ti layer and the Au layer. Therefore, in an FET operation at the normal temperature for a short duration, the defects due to the reaction of GaAs with Au does not matter. However, in a reliability test for a long duration in which a variety of stresses are applied to the gate electrode, Au travels from the side surfaces of the Au layer to be the uppermost layer of the gate electrode to the GaAs layer through the side surfaces of the gate electrode, so that the reaction of GaAs with Au is caused.

### SUMMARY OF THE INVENTION

It is an object of the present invention to provide a gate electrode that suppresses the diffusion of Au from an Au layer to be an upper layer of the gate electrode into a GaAs layer through the side surfaces of the gate electrode to improve reliability of a GaAs FET to a great extent, and a fabricating method of the gate electrode.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, an electrode of a semiconductor device includes a laminated structure laminating a plurality of layers comprising conductive materials on a surface of a semiconductor layer, and a side barrier layer disposed on prescribed regions of the side surfaces of the laminated structure and comprising a conductive material which can prevent a conductive material of a specific layer constituting the laminated structure except a lowermost layer making contact with the semiconductor layer from diffusing into the semiconductor layer through the side surfaces of the laminated structure. Therefore, the side barrier layer prevents the conductive material reacting with the semiconductor layer from diffusing into the semiconductor layer through the side surfaces of the laminated structure, and erosion of the semiconductor layer and deterioration of a contact between the electrode and the semiconductor layer due to the reaction of the semiconductor layer with the conductive material are not caused, whereby the reliability of the semiconductor device in which this electrode is provided is improved.

According to a second aspect of the present invention, in the electrode of the semiconductor device according to the first aspect of the invention, the laminated structure includes a layer comprising Au as the specific layer except the lowermost layer, and the side barrier layer comprises a conductive material which can prevent the diffusion of Au from the layer comprising Au into the semiconductor layer through the side surfaces of the laminated structure and is disposed at least on a region including the side surface of the layer comprising Au. Therefore, although Au reacts with the semiconductor layer, such as a GaAs layer, to erode the semiconductor layer and deteriorate a contact between the electrode and the semiconductor layer, the side barrier layer prevents Au from diffusing into the semiconductor layer through the side surfaces of the laminated structure. Consequently, the erosion of the semiconductor layer and the deterioration of a contact between the electrode and the semiconductor layer due to the reaction of the semiconductor layer with Au are not caused, whereby the reliability of the semiconductor device in which this electrode is provided is improved.

According to a third aspect of the present invention, the electrode of the semiconductor device according to the second aspect of the invention includes an intermediate barrier layer constituting the laminated structure and comprising a conductive material which can prevent the diffusion of Au from the layer comprising Au into the semiconductor layer, and the intermediate barrier layer is disposed below the layer comprising Au and above the lowermost layer. Therefore, the intermediate barrier layer prevents Au from diffusing into the semiconductor layer through the lowermost layer, and the side barrier layer prevents the diffusion of Au into the semiconductor layer through the side surfaces of the laminated structure. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a fourth aspect of the present invention, in the electrode of the semiconductor device according to the third aspect of the invention, the intermediate barrier layer comprises the same material as the side barrier layer and those layers are formed as a continuous layer, and the side barrier layer is disposed on the side surface of the laminated structure above the intermediate barrier layer. Therefore, the barrier layers which prevent the diffusion of Au are continuously disposed on the bottom surface and the side surface of the upper layer portion of the laminated structure comprising the Au layer which is disposed above the intermediate barrier layer, whereby Au is prevented from diffusing into the semiconductor layer through the lowermost layer and the side surface of the laminated structure. Consequently, erosion of the semiconductor layer and deterioration of a contact between the electrode and the semiconductor layer due to the reaction of the semiconductor layer with Au do not occur, whereby the reliability of the semiconductor device in which this electrode is provided is improved.

According to a fifth aspect of the present invention, the electrode of the semiconductor device according to the fourth aspect of the invention includes a side covering layer comprising the same material as the lowermost layer and formed as a continuous layer with the lowermost layer on the surface of the side barrier layer. Therefore, the diffusion of Au into the semiconductor layer through the side surfaces of the laminated structure is prevented, and erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a sixth aspect of the present invention, in the electrode of the semiconductor device according to any of second to fifth aspects of the invention, since the lowermost layer comprises Ti, WSiₓ, or WSiₓN_{y}, a contact between the electrode and the semiconductor layer, i.e., a contact between the lowermost layer and the semiconductor layer is made stable. In addition, the intermediate barrier layer and the side barrier layer prevent Au from diffusing into the semiconductor layer. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a seventh aspect of the present invention, in the electrode of the semiconductor device according to the second or third aspect of the invention, since the side barrier layer comprises Pt, Mo, TiNₓ, W, WSiₓ, or WSiₓN_{y}, the diffusion of Au into the semiconductor layer through the side surfaces of the laminated structure is effectively prevented by the side barrier layer. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to an eighth aspect of the present invention, in the electrode of the semiconductor device according to any of third to fifth aspects of the invention, since the intermediate barrier layer comprises Pt, Mo, TiNₓ, W, WSiₓ or WSiₓN_{y}, the diffusion of Au into the semiconductor layer is effectively prevented by the intermediate barrier layer and the side barrier layer. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a ninth aspect of the present invention, in the electrode of the semiconductor device according to the second aspect of the invention, the lowermost layer comprises a conductive material which can prevent Au from diffusing from the layer comprising Au into the semiconductor layer, the side barrier layer comprises the same material as the lowermost layer and those layers are formed as a continuous layer. Therefore, the layers which prevent the diffusion of Au are continuously disposed on the bottom surface and the side surface of the upper layer portion of the laminated structure comprising the Au layer which is disposed above the lowermost layer, whereby the diffusion of Au into the semiconductor layer through the lowermost layer and the side surface of the laminated structure is prevented. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a tenth aspect of the present invention, in the electrode of the semiconductor device according to the ninth aspect of the invention, since the lowermost layer and the side barrier layer comprise WSiₓ or WSiₓN_{y}, the WSiₓ layers or the WSiₓN_{y} layers which prevent the diffusion of Au are continuously disposed on the bottom surface and the side surface of the upper layer portion of the laminated structure comprising the Au layer which is disposed above the lowermost layer, the diffusion of Au into the semiconductor layer through the lowermost layer and the side surface of the laminated structure is effectively prevented. Consequently, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to an eleventh aspect of the present invention, a fabricating method of an electrode of a semiconductor device includes forming a groove in a portion of a semiconductor layer where an electrode is to be produced by dry etching, depositing a first film comprising a conductive material over the side surface and the bottom surface in the groove to form a side covering layer and a lowermost layer of a laminated structure, depositing a second film comprising a conductive material which can prevent the diffusion of Au over the surfaces of the side covering layer and the lowermost layer to form a side barrier layer and an intermediate barrier layer of a laminated structure, depositing an upper film comprising Au of a low resistance metal over the surfaces of the side barrier layer and the intermediate barrier layer so that it is embedded in the groove to form an upper layer portion of a laminated structure, and forming a recess by etching prescribed portions of the semiconductor layer adjacent to the side surfaces of the groove, thereby forming an electrode that includes a laminated structure in the recess successively laminating the lowermost layer, the intermediate barrier layer, and the upper layer portion, and the side barrier layer and the side covering layer which are formed over the side surface of the laminated structure. Therefore, the electrode in which the bottom surface and the side surface of the upper layer portion comprising the Au layer are covered with the intermediate barrier layer and the side barrier layer, and the outside surfaces thereof are completely covered with the lowermost layer and the side covering layer can be easily fabricated. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a twelfth aspect of the present invention, a fabricating method of an electrode of a semiconductor device includes forming a groove in a portion of a semiconductor layer where an electrode is to be produced by dry etching, depositing a first film comprising a conductive material only over the bottom surface in the groove to form a lowermost layer of a laminated structure, depositing a second film comprising a conductive material which can prevent the diffusion of Au over the side surface of the groove and the surface of the lowermost layer to form a side barrier layer and an intermediate barrier layer of a laminated structure, depositing an upper film comprising Au of a low resistance metal over the surfaces of the side barrier layer and the intermediate barrier layer so that it is embedded in the groove to form an upper layer portion of a laminated structure, and forming a recess by etching prescribed portions of the semiconductor layer adjacent to the side surfaces of the groove, thereby forming an electrode that includes a laminated structure in the recess successively laminating the lowermost layer, the intermediate barrier layer, and the upper layer portion, and the side barrier layer which is formed on the side surface of the laminated structure. Therefore, since the lowermost layer of the laminated structure is formed only on the bottom surface of the groove and it is not required to be formed on the side surface of the groove, the electrode in which the bottom surface and the side surface of the upper layer portion of the laminated structure comprising the Au layer are covered with the intermediate barrier layer and the side barrier layer can be fabricated more easily and stably than in the fabricating method according to the eleventh aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a thirteenth aspect of the present invention, in the fabricating method of the electrode of the semiconductor device according to the eleven or twelfth aspect of the invention, the deposition of the first and second films is carried out using sputtering technique. Therefore, the lowermost layer of the laminated structure and the side barrier layer can be easily formed not only on the bottom surface but on the side surface in the groove formed in the semiconductor layer.

According to a fourteenth aspect of the present invention, in the fabricating method of the electrode of the semiconductor device according to the eleventh aspect of the invention, the deposition of the first and second films is carried out using oblique vacuum evaporation. Therefore, the lowermost layer of the laminated structure and the side barrier layer can be easily formed not only on the bottom surface but on the side surface in the groove formed in the semiconductor layer.

According to a fifteenth aspect of the present invention, in the fabricating method of the electrode of the semiconductor device according to the twelfth aspect of the invention, the deposition of the second film is carried out using oblique vacuum evaporation. Therefore, the side barrier layer can be easily formed not only on the bottom surface but on the side surface in the groove formed in the semiconductor layer.

According to a sixteenth aspect of the present invention, in the fabricating method of the electrode of the semiconductor device according to the eleventh or twelfth aspect of the invention, the deposition of the first and second films is carried out using Chemical Vapor Deposition (CVD). Therefore, the lowermost layer of the laminated structure and the side barrier layer can be easily formed not only on the bottom surface but on the side surface in the groove formed in the semiconductor layer.

According to a seventeenth aspect of the present invention, a fabricating method of an electrode of a semiconductor device includes forming a resist on a region of a semiconductor layer except a region where a recess is to be produced, etching the portion of the semiconductor layer using the resist as a mask to form a recess, successively depositing a first film comprising a conductive material and a second film comprising a conductive material which can prevent the diffusion of Au on the bottom surface of the recess by performing oblique vacuum evaporation using the resist as a mask so that the films have a concavity to form a lowermost layer of a laminated structure and a side covering layer comprising the first film and an intermediate barrier layer of a laminated structure and a side barrier layer comprising the second film, and depositing an upper film comprising Au of a low resistance metal over the inner surfaces of the side barrier layer and the intermediate barrier layer having a concavity using the resist as a mask so that it is embedded in the concavity to form an upper layer portion of a laminated structure, thereby forming an electrode that includes a laminated structure successively laminating the lowermost layer, the intermediate barrier layer, and the upper layer portion, and the side barrier layer and the side covering layer which are formed on the side surface of the laminated structure. Therefore, since the resist mask used for the etching of the semiconductor layer for forming the recess and the resist mask used for the formation of all layers constituting the electrode are the same, the electrode in which the bottom surface and the side surface of the upper layer portion comprising the Au layer are covered with the intermediate barrier layer and the side barrier layer and the outside surfaces thereof completely covered with the lowermost layer and the side covering layer can be fabricated more easily than in the fabricating method according to the eleventh aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to an eighteenth aspect of the present invention, a fabricating method of an electrode of a semiconductor device includes forming a resist on a region of a semiconductor layer except a region where a recess is to be produced, etching the portion of the semiconductor layer using the resist as a mask to form a recess, depositing a first film comprising a conductive material on the bottom surface of the recess using the resist as a mask to form a lowermost layer of a laminated structure, depositing a second film comprising a conductive material which can prevent the diffusion of Au on the lowermost layer by performing oblique vacuum evaporation using the resist as a mask so that the film has a concavity to form an intermediate barrier layer of a laminated structure and a side barrier layer, and depositing an upper film comprising Au of a low resistance metal over the inner surface of the side barrier layer and the intermediate barrier layer having a concavity using the resist as a mask so that it is embedded in the concavity to form an upper layer portion of a laminated structure, thereby forming an electrode that includes a laminated structure successively laminating the lowermost layer, the intermediate barrier layer, and the upper layer portion, and the side barrier layer which is formed on the side surface of the laminated structure. Therefore, since the resist mask used for the etching of the semiconductor layer for forming the recess and the resist mask used for the formation of all layers constituting the electrode are the same, the electrode in which the bottom surface and the side surface of the upper layer portion of the laminated structure comprising the Au layer are covered with the intermediate barrier layer and the side barrier layer can be fabricated more easily than in the fabricating method according to the twelfth aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a nineteenth aspect of the present invention, a fabricating method of an electrode of a semiconductor device includes successively depositing a first film comprising a conductive material on a region of a semiconductor layer where an electrode is to be produced, a second film comprising a conductive material which can prevent the diffusion of Au, and an upper film comprising Au of a low resistance metal to form a laminated structure laminating a lowermost layer comprising the first film, an intermediate barrier layer comprising the second film, and an upper layer portion comprising the upper film, forming an insulating film on a region of the semiconductor layer except the region where the laminated structure is formed to expose at least the entire side surface of the upper layer portion of the laminated structure over the surface of the insulating film, depositing a barrier film comprising a conductive material which can prevent the diffusion of Au over the entire surface of the insulating film and the laminated structure including the exposed side surface, forming a resist on the barrier film covering the laminated structure and selectively etching the barrier film using the resist as a mask to form a side barrier layer comprising the barrier film over the front surface and the side surface of the upper layer portion of the laminated structure, and removing the resist to form an electrode including the laminated structure and the side barrier layer. Therefore, the prior art method of fabricating the electrode in which the lowermost layer, the intermediate barrier layer, and the upper layer portion are successively laminated can be used for the formation of the laminated structure. In addition, it is not necessary to etch portions of the semiconductor layer on opposite sides of the electrode after the formation of all layers constituting the electrode as in the fabricating method according to the eleventh or twelfth aspect of the invention. If a recess is required, the etching of the semiconductor layer may be performed before the formation of the laminated structure. More specifically, the electrode in which the front surface, the bottom surface, and the side surface of the upper layer portion of the laminated structure including the Au layer are covered with the intermediate barrier layer and the side barrier layer can be fabricated more easily and stably than in the fabricating method according to the eleventh or twelfth aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a twentieth aspect of the present invention, a fabricating method of an electrode of a semiconductor device includes successively depositing a first film comprising a conductive material on a region of a semiconductor layer where an electrode is to be produced, a second film comprising a conductive material which can prevent the diffusion of Au, and an upper film comprising Au of a low resistance metal to form a laminated structure laminating a lowermost layer comprising the first film, an intermediate barrier layer comprising the second film, and an upper layer portion comprising the upper film, forming an insulating film on a region of the semiconductor layer except the region where the laminated structure is formed to expose at least the entire side surface of the upper layer portion of the laminated structure over the surface of the insulating film, depositing a barrier film comprising conductive material which can prevent the diffusion of Au over the entire surface of the insulating film and the laminated structure including the exposed side surface, and performing an anisotropic etching to the barrier film to remove the barrier film except the portion covering the side surface of the upper layer portion of the laminated structure, thereby forming an electrode that includes the laminated structure and a side barrier layer comprising the barrier film which is left on the side surface of the upper layer portion. Therefore, since it is not necessary to use a mask for the etching of the barrier film, the electrode in which the bottom surface and the side surface of the upper layer portion of the laminated structure comprising the Au layer are covered with the intermediate barrier layer and the side barrier layer can be fabricated more easily than in the fabricating method according to the nineteenth aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a twenty-first aspect of the present invention, a fabricating method of an electrode of a semiconductor device includes forming a groove in a portion of a semiconductor layer where an electrode is to be produced by dry etching, depositing a film comprising a conductive material which can prevent the diffusion of Au over the side surface and the bottom surface in the groove to form a side barrier layer and a lowermost layer of a laminated structure, depositing an upper film comprising Au of a low resistance metal over the surfaces of the side barrier layer and the lowermost layer so that it is embedded in the groove to form an upper layer portion of a laminated structure, and forming a recess by etching prescribed portions of the semiconductor layer adjacent to the side surfaces of the groove, thereby forming an electrode that includes a laminated structure in the recess laminating the lowermost layer and the upper layer portion, and the side barrier layer which is formed on the side surface of the laminated structure. Therefore, since the lowermost layer has the function of an intermediate barrier layer which prevents the diffusion of Au and it is not necessary to form the intermediate barrier layer in the fabricating method according to the eleventh or twelfth aspect of the invention, the electrode in which the bottom surface and the side surface of the upper layer portion of the laminated structure comprising the Au layer are covered with the lowermost layer and the side barrier layer can be fabricated more easily than in the fabricating method according to the eleventh or twelfth aspect of the invention. This electrode structure can prevent Au from diffusing into the semiconductor layer through the lowermost layer and the side surface of the laminated structure. As a result, erosion of the semiconductor layer and deterioration of a contact between the electrode and the semiconductor layer due to the reaction of the semiconductor layer with Au are not caused, whereby the reliability of the semiconductor device in which this electrode is provided is improved.

According to a twenty-second aspect of the present invention, in the fabricating method of the electrode of the semiconductor device according to the eleventh, twelfth, or twenty-first aspect of the invention, an etching stopper layer is provided in the semiconductor layer, the etching of the semiconductor layer for forming the groove and for removing prescribed portions of the semiconductor layer adjacent to the side surfaces in the groove after the formation of all layers constituting the electrode in the groove are stopped automatically when the etching stopper layer is exposed. Therefore, the etching of the semiconductor layer is excellent in uniformity and reproducibility, and the bottom surface of the electrode and the bottom surface of the recess are easily put on the same plane, resulting in good yield of the semiconductor device including the electrode which is fabricated using this method.

According to a twenty-third aspect of the present invention, in the fabricating method of the electrode of the semiconductor device according to the twenty-second aspect of the invention, since the etching stopper layer comprises AlGaAs, the etching of the semiconductor layer is easily stopped automatically due to the AlGaAs layer. Therefore, this etching is excellent in uniformity and reproducibility, and the bottom surface of the electrode and the bottom surface of the recess are easily put on the same plane, resulting in good yield of the semiconductor device including the electrode which is fabricated using this method.

### BRIEF DESCRIPTION OF THE DRAWINGS

Figure 1 is a cross-sectional view illustrating a gate electrode in accordance with a first embodiment of the present invention.

Figures 2(a)-2(e) are cross-sectional views illustrating process steps in a method of fabricating the gate electrode in accordance with the first embodiment of the present invention.

Figure 3 is a cross-sectional view illustrating a method of fabricating a gate electrode which is disposed on an etching stopper layer in accordance with the first embodiment of the present invention.

Figure 4(a)-4(c) are cross-sectional views illustrating process steps in a method of fabricating a gate electrode in accordance with a second embodiment of the present invention.

Figure 5 is a cross-sectional view illustrating a gate electrode in accordance with a third embodiment of the present invention.

Figures 6(a)-6(e) are cross-sectional views illustrating process steps in a method of fabricating the gate electrode in accordance with the third embodiment of the present invention.

Figure 7 is a cross-sectional view illustrating a method of fabricating a gate electrode which is disposed on an etching stopper layer in accordance with the third embodiment of the present invention.

Figures 8(a)-8(d) are cross-sectional views illustrating process steps in a method of fabricating a gate electrode in accordance with a fourth embodiment of the present invention.

Figure 9 is a cross-sectional view illustrating a gate electrode in accordance with a fifth embodiment of the present invention.

Figures 10(a)-10(c) are cross-sectional views illustrating process steps in a method of fabricating the gate electrode in accordance with the fifth embodiment of the present invention.

Figure 11 is a cross-sectional view illustrating a gate electrode in accordance with a sixth embodiment of the present invention.

Figures 12(a) and 12(b) are cross-sectional views illustrating process steps in a method of fabricating the gate electrode in accordance with the sixth embodiment of the present invention.

Figure 13 is a cross-sectional view illustrating a gate electrode in accordance with a seventh embodiment of the present invention.

Figures 14(a) and 14(b) are cross-sectional views illustrating process steps in a method of fabricating the gate electrode in accordance with the seventh embodiment of the present invention.

Figure 15 is a cross-sectional view illustrating a conventional gate electrode.

### DETAILED DESCRIPTION OF THE PREFERRED EMBODIMENT

### [Embodiment 1]

A description is given of a first embodiment of the present invention.

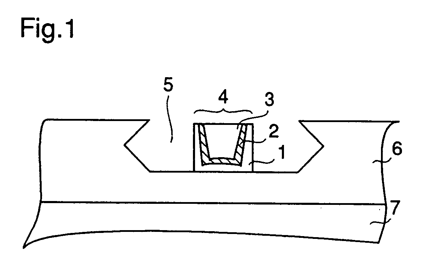

Figure 1 is a cross-sectional view illustrating a gate electrode of a GaAs FET according to this first embodiment of the invention. In the figure, reference numeral 7 designates a GaAs substrate, numeral 6 designates an n type GaAs layer serving as an operating layer of the FET, and numeral 5 designates a gate recess formed in the n type GaAs layer 6. Reference numeral 4 designates a gate electrode comprising Ti/Pt/Au. A Ti layer 1 is a lowermost layer of the gate electrode 4, a Pt layer 2 is an intermediate barrier layer of the gate electrode, and an Au layer 3 is an uppermost layer of the gate electrode.

In the gate electrode structure shown in figure 1, the bottom surface and the side surfaces of the Au layer 3 are covered with the Pt layer 2, and the bottom surface and the side surfaces of the Pt layer 2 are covered with the Ti layer 1. Therefore, the Pt layer 2 prevents Au from diffusing into the GaAs layer 6 through the side surfaces of the gate electrode and reacting with the n type GaAs layer 6, whereby the n type GaAs layer is not eroded by Au and a Schottky contact between the gate electrode and the n type GaAs layer is not deteriorated. Consequently, the reliability of the FET in which this gate electrode is provided is improved.

A description is given of the fabricating method.

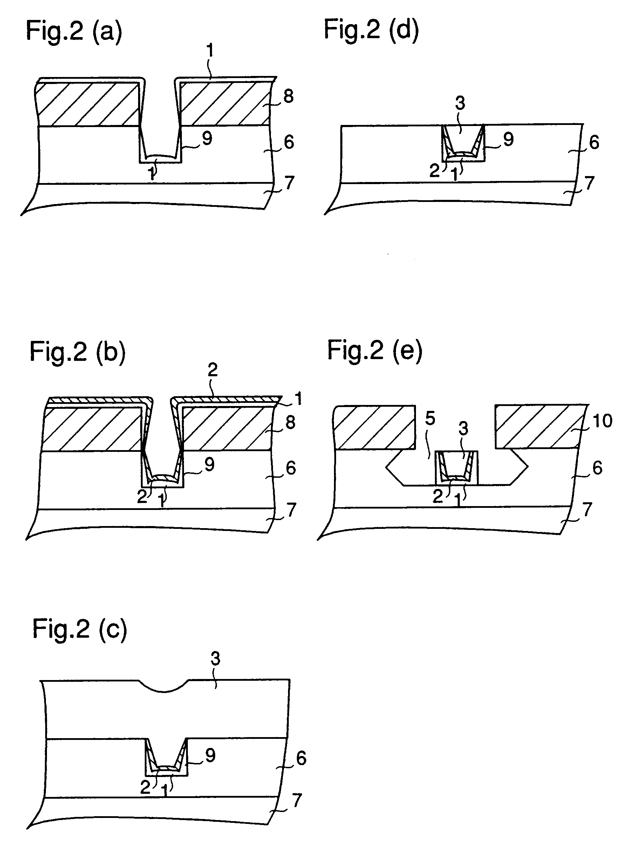

Initially, a heat-resistant resist 8 is formed on an n type GaAs layer 6 except a portion where a groove is to be produced. Using the resist 8 as a mask, a groove 9 is formed by dry etching in the portion of the n type GaAs layer 6 where a gate electrode is to be produced (Figure 2(a)). Thereafter, Ti and Pt are deposited in this order over the entire surface of the wafer using sputtering technique or CVD (Chemical Vapor Deposition) (figure 2(b)). In this deposition, not only the bottom surface but the side surfaces in the groove 9 are covered with Ti and Pt. Then, the heat-resistant resist 8 and portions of Ti and Pt on the surface of the resist 8 are removed leaving a Ti layer 1 and a Pt layer 2 in the groove 9. In the step of figure 2(c), Au is deposited over the entire surface of the wafer using sputtering technique or CVD. Further, Au is etched using ion milling until the surface of the GaAs layer 6 is exposed, so that an Au layer 3 is embedded in the groove 9, i.e., over the Pt layer 2 (figure 2(d)). In the step of figure 2(e), a resist 10 is formed on the GaAs layer 6 and, using the resist 10 as a mask, portions of the GaAs layer 6 on opposite sides of the gate electrode are etched away to form a gate recess 5, followed by removal of the resist 10, resulting in the gate electrode structure shown in figure 1.

As described above, the gate electrode structure in which the bottom surface and the side surfaces of the Au layer 3 are covered with the Pt layer 2 and the Ti layer 1 is easily fabricated with the fabricating process according to the first embodiment of the present invention.

While in the above-described fabricating method the Ti layer and the Pt layer are formed using sputtering technique or CVD, oblique vacuum evaporation may be used for the formation. In addition, after the removal of the heat-resistant resist, the Au layer is formed using sputtering technique or CVD. However, without removing the heat-resistant resist after the deposition of Ti and Pt, Au is deposited over the entire surface of the wafer using vacuum evaporation, and the heat-resistant resist is removed, whereby the Au layer may be left only in the groove 9.

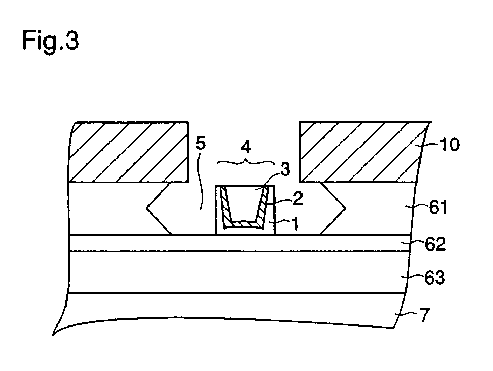

In the above-described fabricating method, when the portions of the GaAs layer 6 on opposite sides of the gate electrode are etched after the formation of the Au layer 3, the bottom surface of the gate recess 5 and the bottom surface of the gate electrode 4 are put on the same plane. If the bottom surface of the gate recess 5 is higher than the bottom surface of the gate electrode, portions of the side surfaces of the gate electrode make contact with the n type GaAs layer 6, resulting in an increased gate capacitance, which deteriorates a high frequency characteristic of the FET. Meanwhile, if the bottom surface of the gate recess 5 is positioned lower than the bottom surface of the gate electrode, the n type GaAs layer 6 except at the gate region becomes thin, whereby the source resistance and the drain resistance are increased to deteriorate an electric characteristic of the FET. Therefore, it is desirable to put the bottom surfaces of the gate recess and the gate electrode on the same plane. For that purpose, it is necessary to control precisely the depth of the recess in gate recess etching. In order to realize that, an etching stopper layer 62 comprising n type AlGaAs is inserted between the n type GaAs layers 61 and 63 as shown in figure 3, whereby the etching for forming the gate recess 5 is stopped automatically at the plane as high as the bottom surface of the gate electrode. In addition, the etching stopper layer 62 serves as an etching stopper layer also in the etching for forming the groove 9. Consequently, the etching processes are made easy and stable, whereby yield of the FET is improved.

While in the first embodiment of the invention the Ti layer and the Pt layer are used as the lowermost layer and the intermediate barrier layer of the gate electrode, respectively, WSiₓ and WSiₓN_{y} may be used for the lowermost layer, and Mo, TiNₓ, W, WSiₓ, and WSiₓN_{y} may be used for the intermediate barrier layer.

Further, while the electrode structure and the fabricating method thereof according to the first embodiment of the invention relates to the gate electrode of the FET, these are applicable to a base electrode of a heterojunction bipolar transistor. Likewise, this does apply for all embodiments described hereinafter.

### [Embodiment 2]

A description is given of a second embodiment of the present invention.

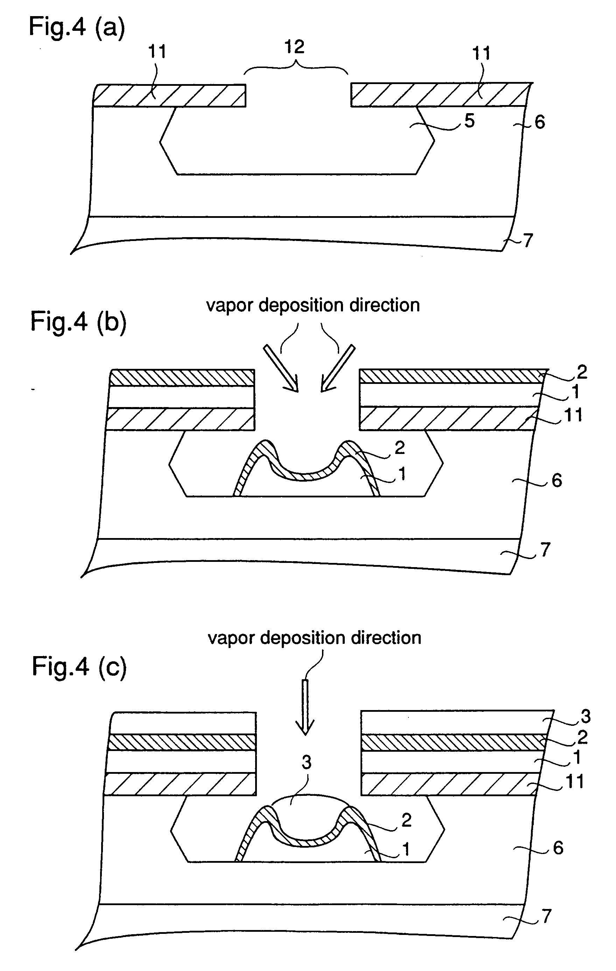

Figures 4(a)-4(c) are cross-sectional views illustrating process steps in a method of fabricating a gate electrode according to this second embodiment of the invention. Initially, as shown in figure 4(a), a resist 11 having an aperture portion 12 is formed on an n type GaAs layer 6 which is formed on a GaAs substrate 7 and, then, using the resist 11 as a mask, a portion of the n type GaAs layer 6 below the aperture portion 12 of the resist 11 is etched to form a gate recess 5. Then, as shown in figure 4(b), using the resist 11 as a mask, Ti and Pt are deposited in this order using oblique vacuum evaporation, thereby forming a Ti layer 1 and a Pt layer 2 on the bottom surface of the gate recess 5. This oblique vacuum evaporation is performed from two directions along arrows shown in the figure. The Ti layer 1 and the Pt layer 2 formed on the bottom surface of the gate recess 5 have a concavity. Further, as shown in figure 4(c), Au is deposited in the direction perpendicular to the substrate, whereby an Au layer 3 is formed over the inner surface of the concavity of the Pt layer 2. Finally, the resist 11 is removed, resulting in the gate electrode structure similar to the structure shown in figure 1, in which the bottom surface and the side surfaces of the Au layer 3 are covered with the Pt layer 2 and the outside of the Pt layer 2 is covered with the Ti layer 1.

In this second embodiment of the invention, each metal material is deposited using vacuum evaporation, and this deposition and the etching for forming the gate recess are performed using the same resist mask. Therefore, the processes are made easier than in the first embodiment. More specifically, in the fabricating method of the gate electrode according to the second embodiment of the invention, the gate electrode structure in which the bottom surface and the side surfaces of the Au layer 3 are covered with the Pt layer 2 and the Ti layer 1 is fabricated more easily than in the first embodiment.

Also in this gate electrode, the Pt layer 2 prevents Au from diffusing into the GaAs layer 6 through the side surfaces of the gate electrode and reacting with the n type GaAs layer 6, whereby the n type GaAs layer is not eroded by Au and a Schottky contact between the gate electrode and the n type GaAs layer is not deteriorated. Consequently, the reliability of the FET in which this gate electrode is provided is improved.

### [Embodiment 3]

A description is given of a third embodiment of the present invention.

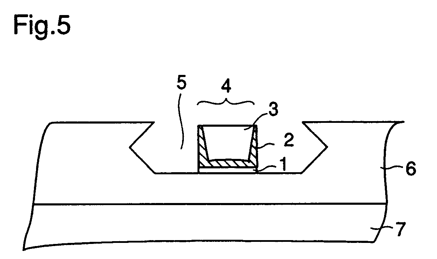

Figure 5 is a cross-sectional view illustrating a gate electrode according to this third embodiment of the invention. In the figure, reference numeral 7 designates a GaAs substrate, numeral 6 designates an n type GaAs layer serving as an operating layer of an FET, and numeral 5 designates a gate recess formed in the n type GaAs layer 6. Reference numeral 4 designates a gate electrode comprising Ti/Pt/Au. A Ti layer 1 is a lowermost layer of the gate electrode 4, a Pt layer 2 is an intermediate barrier layer of the gate electrode, and an Au layer 3 is an uppermost layer of the gate electrode.

In the gate electrode shown in figure 5, the bottom surface and the side surfaces of the Au layer 3 are covered with the Pt layer 2. Therefore, the Pt layer 2 prevents Au from diffusing into the GaAs layer 6 through the side surfaces of the gate electrode 4 and reacting with the n type GaAs layer 6, thereby preventing erosion of the n type GaAs layer and deterioration of a Schottky contact between the gate electrode and the n type GaAs layer. Consequently, the reliability of the FET in which this gate electrode is provided is improved.

A description is given of the fabricating method.

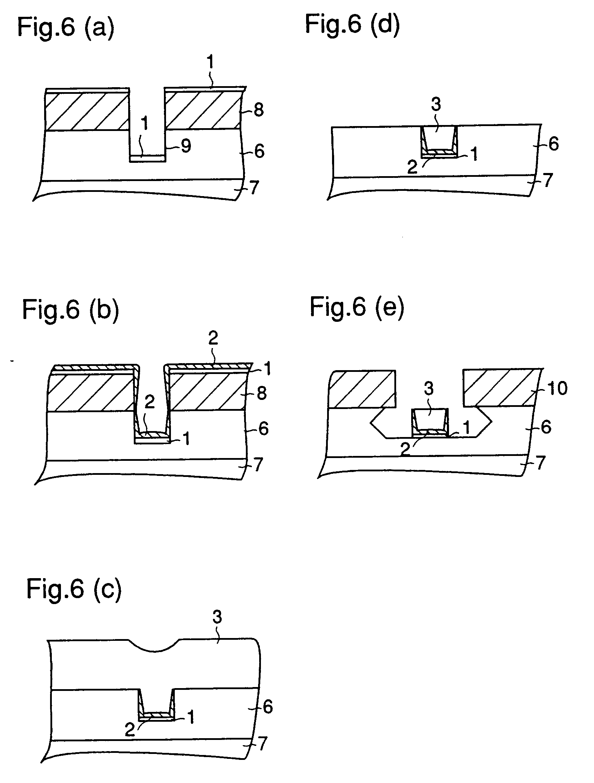

Initially, a heat-resistant resist 8 is formed on an n type GaAs layer 6 except a portion where a groove is to be produced and, using the resist 8 as a mask, a groove 9 is formed by dry etching in a portion of the n type GaAs layer 6 where a gate electrode is to be produced. Then, Ti is deposited over the entire surface of the wafer using vacuum evaporation. This deposition is performed in the direction perpendicular to the substrate surface, and a Ti layer 1 is formed only on the bottom surface of the groove 9 (figure 6(a)). The subsequent processes are the same as in the first embodiment of the invention. As shown in figure 6(b), Pt is deposited to form a Pt film 2 over the entire surface of the wafer using sputtering technique or CVD. In this deposition, not only on the bottom surface, i.e., on the Ti layer, but on the side surfaces in the groove 9 the Pt film is deposited. Thereafter, the heat-resistant resist 8 and portions of Ti and Pt on the surface of the resist 8 are removed leaving the Ti layer 1 and the Pt layer 2 only in the groove 9. Then, as shown in figure 6(c), Au is deposited over the entire surface of the wafer using sputtering technique or CVD. Further, using ion milling, Au is etched until the surface of the GaAs layer 6 is exposed, so that an Au layer 3 is embedded in the groove 9, i.e., over the Pt layer 2 (figure 6(d)). In the step of figure 6(e), a resist 10 is formed on the GaAs layer 6 and, using the resist 10 as a mask, portions of the GaAs layer 6 on opposite sides of the gate electrode are etched away to form a gate recess 5, followed by removal of the resist 10, resulting in the gate electrode structure shown in figure 5.

In the fabricating method of the gate electrode according to the third embodiment of the invention, since the Ti layer is formed using vacuum evaporation, Ti is not deposited on the side walls of the heat-resistant resist 8 on the groove 9 in the GaAs layer 6, and Pt which is deposited after the deposition of Ti is left only on these side walls. Therefore, compared with the case where both Ti and Pt are deposited on the side walls of the resist 8 as in the first embodiment, the removal of the heat-resistant resist is facilitated. Consequently, in the third embodiment of the invention, the gate electrode structure shown in figure 5, in which the bottom surface and the side surfaces of the Au layer 3 are covered with the Pt layer 2, is fabricated more easily than in the first embodiment.

While in the above-described fabricating method the Ti layer is formed using vacuum evaporation, sputtering technique or CVD may be used for the deposition. While the Pt layer is formed using sputtering technique or CVD, oblique vacuum evaporation may be used. Further, the Au layer is formed using sputtering technique or CVD after the removal of the heat-resistant resist. However, without removing the heat-resistant resist after the deposition of Ti and Pt, Au is deposited over the entire surface of the wafer using vacuum evaporation and, then, the heat-resistant resist is removed, whereby the Au layer is left only in the groove.

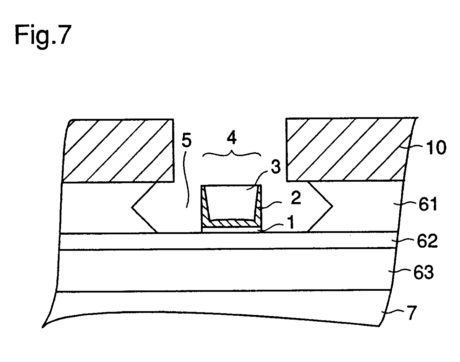

Also in the above-described fabricating method, when the portions of the GaAs layer 6 on opposite sides of the gate electrode are etched after the formation of the Au layer, the bottom surface of the gate recess 5 which is formed due to the etching and the bottom surface of the gate electrode 4 are put on the same plane. The reason is as described in the first embodiment. Therefore, it is required to control precisely the depth of the recess in gate recess etching. In order to realize that, an etching stopper layer 62 comprising n type AlGaAs is inserted between the n type GaAs layers 61 and 63 as shown in figure 7, whereby the etching for forming the gate recess 5 is stopped automatically at the plane as high as the bottom surface of the gate electrode 4. In addition, the etching stopper layer 62 serves as an etching stopper layer also in the etching for forming the groove 9. Consequently, the etching processes are made stable, whereby yield of the FET is improved.

While in the third embodiment of the invention the Ti layer and the Pt layer are used as the lowermost layer and the intermediate barrier layer of the gate electrode, respectively, WSiₓ and WSiₓN_{y} may be used for the lowermost layer, and Mo, TiNₓ, W, WSiₓ, and WSiₓN_{y} may be used for the intermediate barrier layer.

### [Embodiment 4]

A description is given of a fourth embodiment of the present invention.

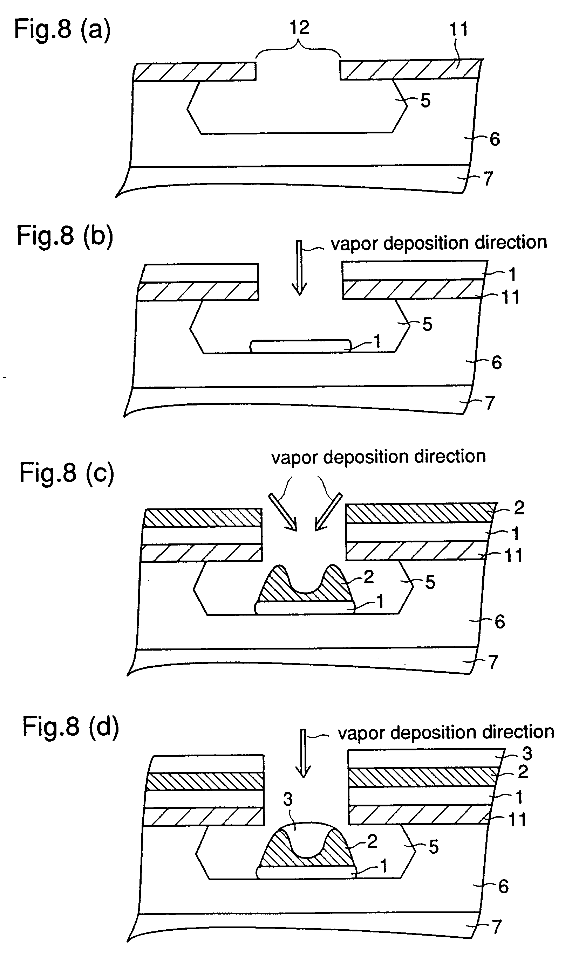

Figures 8(a)-8(d) are cross-sectional views illustrating process steps in a method of fabricating a gate electrode according to the fourth embodiment of the invention. Initially, a resist 11 having an aperture portion 12 is formed on an n type GaAs layer 6 which is formed on a GaAs substrate 7. Using the resist 11 as a mask, a portion of the n type GaAs layer 6 below the aperture portion 12 of the resist 11 is etched to form a gate recess 5 (figure 8(a)). Then, using the resist 11 as a mask, Ti is deposited in the direction perpendicular to the substrate, whereby a Ti layer 1 is formed on the bottom surface of the gate recess 5 (figure 8(b)). Further, Pt is deposited using oblique vacuum evaporation to form a Pt layer 2 on the Ti layer 1 (figure 8(c)). This deposition is performed in two direction along arrows shown in the figure. The Pt layer 2 formed on the Ti layer 1 of the bottom surface of the gate recess 5 has a concavity. Then, the deposition of Au is carried out in the direction perpendicular to the substrate, whereby an Au layer 3 is formed over the inner surface of the concavity of the Pt layer 2 (figure 8(d)). Finally, the resist 11 is removed, resulting in the gate electrode structure similar to the structure shown in figure 5, in which the bottom surface and the side surfaces of the Au layer 3 are covered with the Pt layer 2.

In this fourth embodiment of the invention, each metal material is deposited using vacuum evaporation, and this deposition and the etching for forming the gate recess are performed using the same resist mask. Therefore, the processes are made easier than in the third embodiment. More specifically, in the fabricating method of the gate electrode according to the fourth embodiment of the invention, the gate electrode structure in which the bottom surface and the side surfaces of the Au layer 3 are covered with the Pt layer 2 is fabricated more easily than in the third embodiment.

Also in this gate electrode, the Pt layer 2 prevents Au from diffusing into the GaAs layer 6 through the side surfaces of the gate electrode and reacting with the n type GaAs layer 6, whereby the n type GaAs layer 6 is not eroded by Au and a Schottky contact between the gate electrode and the n type GaAs layer is not deteriorated. Consequently, the reliability of the FET in which this gate electrode is provided is improved.

### [Embodiment 5]

A description is given of a fifth embodiment of the present invention.

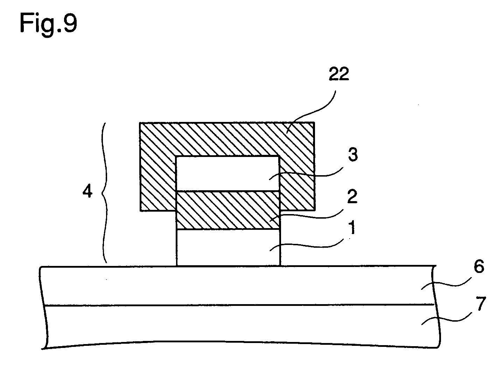

Figure 9 is a cross-sectional view illustrating a gate electrode according to the fifth embodiment of the invention. In the figure, reference numeral 7 designates a GaAs substrate, and numeral 6 designates an n type GaAs layer serving as an operating layer of an FET. Reference numeral 4 designates a gate electrode comprising Ti/Pt/Au. A Ti layer 1 is a lowermost layer of the gate electrode 4, a Pt layer 2 is an intermediate barrier layer of the gate electrode, a Au layer 3 is an uppermost layer of the gate electrode, and a Pt layer 22 is a side barrier layer of the gate electrode.

In the gate electrode structure shown in figure 9, the bottom surface of the Au layer 3 is not only covered with the Pt layer 2 but the side surfaces and the front surface of the Au layer 3 are covered with the Pt layer 22. Therefore, the Pt layer 22 prevents Au from diffusing into the GaAs layer 6 through the side surfaces of the gate electrode and reacting with the n type GaAs layer, whereby the n type GaAs layer 6 is not eroded and a Schottky contact between the gate electrode and the n type GaAs layer is not deteriorated. Consequently, the reliability of the FET in which this gate electrode is provided is improved.

A description is given of the fabricating method.

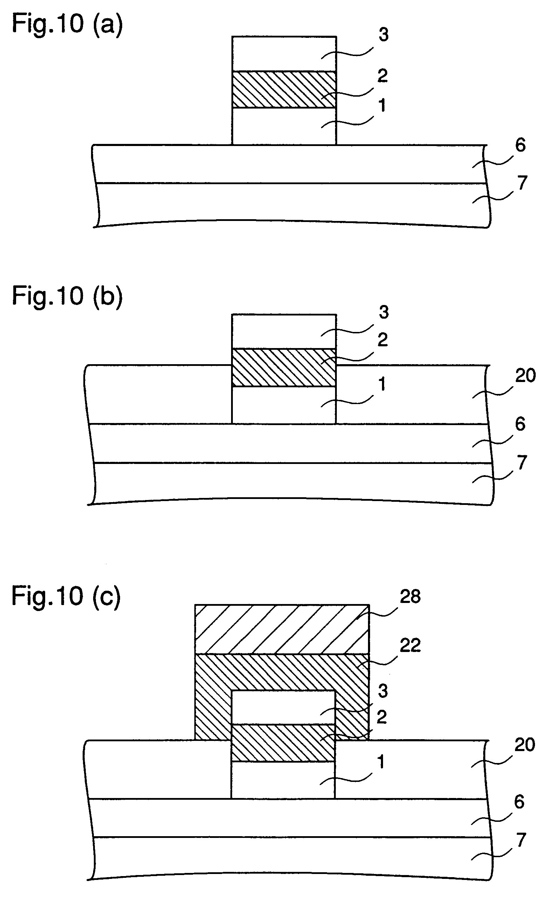

Initially, as shown in figure 10(a), a laminated structure comprising a Ti layer 1 to be a lowermost layer, a Pt layer 2 to be an intermediate barrier layer, and an Au layer 3 to be an uppermost layer is formed on a gate region of an n type GaAs layer 6. More specifically, a resist having an aperture portion over the gate region is formed on the n type GaAs layer 6 and, using the resist as a mask, Ti, Pt, and Au in this order are deposited, followed by removal of the resist, thereby forming this laminated structure. Then, an insulating film, such as an SiON film, 20 is deposited over the entire surface of the wafer, preferably using CVD. Thereafter, the whole of the Au layer 3 and portions of the side surfaces of the Pt layer 2 are exposed over the surface of the insulating film 20 by etching back technique (figure 10(b)). Further, using sputtering technique, CVD, or oblique vacuum evaporation, Pt is deposited over the entire surface of the wafer. In the step of figure 10(c), a resist 28 is formed on a prescribed region of Pt including a region on the laminated structure and, using the resist 28 as a mask, Pt is selectively etched by ion milling until the surface of the insulating film 20 is exposed, whereby a Pt layer 22 covering the front surface and the side surfaces of the Au layer 3 is formed. Finally, the resist 28 and the insulating film 20 are removed, resulting in the gate electrode structure shown in figure 9.

In the fabricating method of the gate electrode according to the fifth embodiment of the invention, the laminated structure comprising the Ti layer 1, the Pt layer 2, and the Au layer 3 can be formed by the prior art method of fabricating the metal gate electrode. In addition, it is not required to etch the portions of the GaAs layer 6 on opposite sides of the gate electrode after the formation of each metal layer constituting the gate electrode as in the first and third embodiments of the invention. If a gate recess is required, using the resist for forming the laminated structure as a mask, the etching of the GaAs layer 6 may be performed before the formation of each metal layer constituting the laminated structure. More specifically, in this fifth embodiment of the invention, the processes are made easier and more stable than in the first and third embodiments.

In the above-described fabricating method, after the exposure of the upper portion of the laminated structure over the insulating film 20, the Pt layer 22 is formed over the entire surface of the wafer using sputtering technique, CVD, or oblique vacuum evaporation. However, after the above-described exposure, a resist having an aperture portion over a prescribed region including the laminated structure region is formed on the insulating film 20 and, then, Pt is deposited over the entire surface of the wafer using sputtering technique, CVD, or oblique vacuum evaporation, followed by removal of the resist, whereby the Pt layer 22 may be formed.

While in this fifth embodiment of the invention the Ti layer is used as the lowermost layer of the gate electrode, WSiₓ and WSiₓN_{y} may be used. While the Pt layers are used as the intermediate barrier layer and the side barrier layer of the gate electrode, Mo, TiNₓ, W, WSiₓ, and WSiₓN_{y} may be used.

### [Embodiment 6]

A description is given of a sixth embodiment of the present invention.

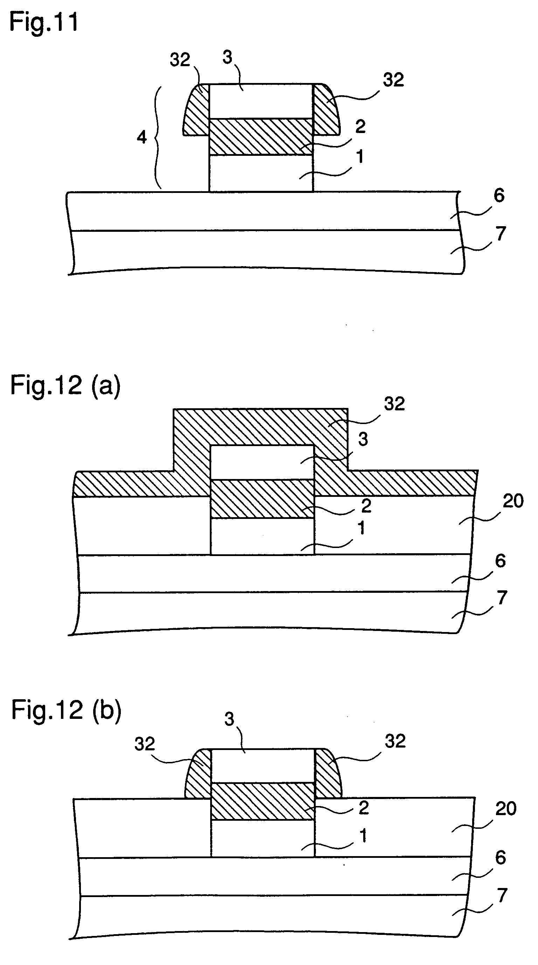

Figure 11 is a cross-sectional view illustrating a gate electrode according to this sixth embodiment of the invention. In the figure, reference numeral 7 designates a GaAs substrate, and numeral 6 designates an n type GaAs layer serving as an operating layer of an FET. Reference numeral 4 designates a gate electrode comprising Ti/Pt/Au. A Ti layer 1 is a lowermost layer of the gate electrode 4, a Pt layer 2 is an intermediate barrier layer of the gate electrode, an Au layer 3 is an uppermost layer of the gate electrode, and a Pt layer 32 is a side barrier layer of the gate electrode.

In the gate electrode shown in figure 11, the bottom surface of the Au layer 3 is not only covered with the Pt layer 2 but each side surface of the Au layer 3 is covered with the Pt layer 32. Therefore, the Pt layer 32 prevents Au from diffusing into the GaAs layer 6 through the side surfaces of the gate electrode and reacting with the n type GaAs layer 6, whereby the n type GaAs layer is not eroded and a Schottky contact between the gate electrode and the n type GaAs layer is not deteriorated. Consequently, the reliability of the FET where this gate electrode is provided is improved. In addition, as in the fifth embodiment of the invention, the front surface of the Au layer 3 is not covered with the Pt layer.

A description is given of the fabricating method.

Initially, similarly to the fifth embodiment, a laminated structure comprising a Ti layer 1 to be a lowermost layer, a Pt layer 2 to be an intermediate barrier layer, and an Au layer 3 to be an uppermost layer is formed on a gate region of an n type GaAs layer 6. Then, an insulating film, such as an SiON film, 20 is deposited over the entire surface of the wafer, preferably using CVD. Thereafter, the whole of the Au layer 3 and portions of the side surfaces of the Pt layer 2 are exposed over the surface of the insulating film 20 by etching back technique. Further, using sputtering technique, CVD, or oblique vacuum evaporation, Pt is deposited over the entire surface of the wafer (figure 12(a)). Pt is etched by ion milling until the surface of the insulating film 20 and the front surface of the Au layer 3 are exposed. Since ion milling is anisotropic etching, Pt is left as side walls only on the exposed side surfaces of the laminated structure, thereby forming a Pt layer 32 covering each side surface of the Au layer 3 (figure 12(b)). Finally, the insulating film 20 is removed, resulting in the gate electrode structure shown in figure 11.

Also in the fabricating method of the gate electrode according to this sixth embodiment of the invention, the laminated structure comprising the Ti layer 1, the Pt layer 2, and the Au layer 3 can be formed by the prior art method of fabricating the metal gate electrode. In addition, it is not required to etch the portions of the GaAs layer 6 on opposite sides of the gate electrode after the formation of each metal layer constituting the gate electrode as in the first and third embodiments of the invention. If a gate recess is required, using the resist for forming the laminated structure as a mask, the etching of the GaAs layer 6 may be performed before the formation of each metal layer constituting the laminated structure. Further, after the deposition of Pt over the entire surfaces of the insulating film and the laminated structure, it is not required to form the resist on Pt as in the fifth embodiment of the invention. More specifically, in this sixth embodiment of the invention, the processes are made easier and more stable than in the first, third, and fifth embodiments.

While in this sixth embodiment of the invention the Ti layer is used as the lowermost layer of the gate electrode, WSiₓ and WSiₓN_{y} may be used. While the Pt layers are used as the intermediate barrier layer and the side barrier layer of the gate electrode, Mo, TiNₓ, W, WSiₓ, and WSiₓN_{y} may be used.

### [Embodiment 7]

A description is given of a seventh embodiment of the present invention.

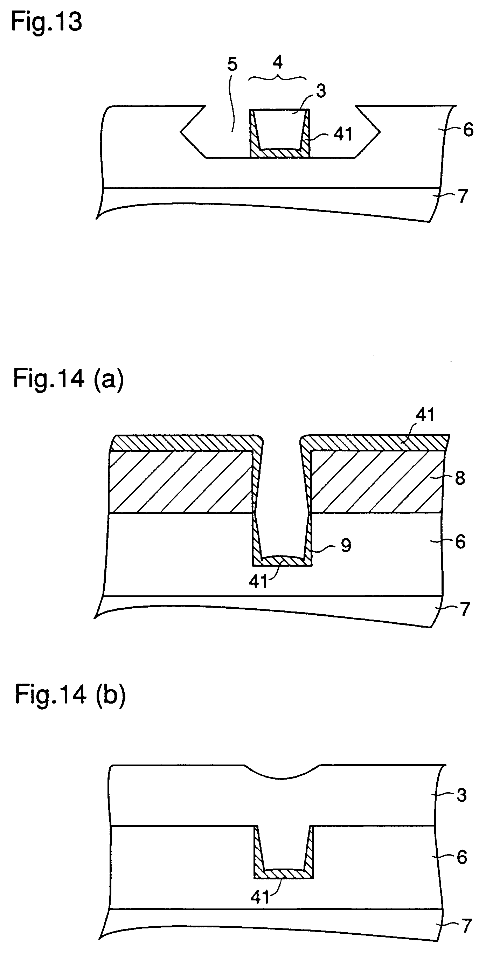

Figure 13 is a cross-sectional view illustrating a gate electrode according to this seventh embodiment of the invention. In the figure, reference numeral 7 designates a GaAs substrate, numeral 6 designates an n type GaAs layer serving as an operating layer of an FET, and numeral 5 designates a gate recess formed in the n type GaAs layer 6. Reference numeral 4 designates a gate electrode comprising WSiₓ/Au. A WSiₓ layer 41 is a lower layer of the gate electrode 4, and an Au layer 3 is an upper layer of the gate electrode.

In the gate electrode shown in figure 13, the bottom surface and the side surfaces of the Au layer 3 are covered with the WSix layer 41. Therefore, the WSix layer 41 prevents Au from diffusing into the GaAs layer 6 through the side surfaces of the gate electrode and reacting with the n type GaAs layer 6, whereby the n type GaAs layer does not eroded and a Schottky contact between the gate electrode and the n type GaAs layer is not deteriorated. Consequently, the reliability of the FET in which this gate electrode is provided is improved. The WSiₓ layer 41 employed in this seventh embodiment fulfills the functions of both the Ti layer and the Pt layer employed in the first to sixth embodiments of the invention. More specifically, the WSix layer 41 makes a good Schottky contact with the n type GaAs layer 6, similarly as the Ti layer, and prevents the diffusion of Au, similarly as the Pt layer.

A description is given of the fabricating method.

Initially, a heat-resistant resist 8 is formed on an n type GaAs layer 6 except a portion where a groove is to be produced and, using the resist 8 as a mask, a groove 9 is formed by dry etching in a portion of the n type GaAs layer 6 where a gate electrode is to be produced. Then, WSix is deposited over the entire surface of the wafer using sputtering technique or CVD (figure 14(a)). In this deposition, the bottom surface and the side surfaces in the groove 9 are covered with WSiₓ. Thereafter, the heat-resistant resist 8 and portions of WSiₓ on the surface of the resist 8 are removed leaving a WSiₓ layer 41 in the groove 9. Then, as shown in figure 14(b), Au is deposited over the entire surface of the wafer using sputtering technique or CVD. The followings are the same processes as in the first to third embodiments of the invention. More specifically, using ion milling, Au is etched until the surface of the GaAs layer 6 is exposed, so that an Au layer 3 is embedded in the groove 9, i.e., over the WSix layer 41. Then, a resist having an aperture portion over a region where a gate recess is to be produced is formed on the GaAs layer 6 and, using the resist as a mask, portions of the GaAs layer 6 on opposite sides of the gate electrode are etched away to form a gate recess 5, followed by removal of the resist, resulting in the gate electrode structure shown in figure 13.

While in the first to third embodiments of the invention it is necessary to form two layers of the Ti layer and the Pt layer, in this seventh embodiment only the WSix layer is formed, whereby the processes are simplified.

In the above-described fabricating method, after removal of the heat-resistant resist, the Au layer 3 is formed using sputtering technique or CVD. However, without removing the heat-resistant resist after the deposition of WSiₓ, Au is deposited over the entire surface of the wafer using vacuum evaporation, followed by removal of the resist, whereby the Au layer 3 may be left only in the groove 9.

Also in the fabricating method according to this seventh embodiment of the invention, when the portions of the GaAs layer 6 on opposite sides of the gate electrode are etched after the formation of the Au layer 3, the bottom surface of the gate recess 5 and the bottom surface of the gate electrode 4 are put on the same plane. The reason is as described in the first embodiment of the invention. Therefore, it is necessary to control precisely the depth of the recess in gate recess etching. Similarly in the first embodiment of the invention, however, since an etching stopper layer comprising n type AlGaAs is inserted between the n type GaAs layers, the etching for forming the gate recess is stopped automatically at the plane as high as the bottom surface of the gate electrode. In addition, the etching stopper layer serves as an etching stopper layer also in the etching for forming the groove 9. Consequently, the etching processes are made stable, whereby yield of the FET is improved.

In this seventh embodiment of the invention, while WSiₓ is used for the lower layer of the gate electrode, WSiₓN_{y} may be used.

## Claims

1. An electrode of a semiconductor device including:
a semiconductor layer (6) having a surface;
a laminated structure laminating a plurality of layers comprising conductive materials on the surface of the semiconductor layer (6) and having a side surface; and
a side barrier layer disposed on the side surface of the laminated structure and comprising a conductive material which can prevent a conductive material of a specific layer constituting the laminated structure except a lowermost layer in contact with the semiconductor layer (6) reacting with the semiconductor layer (6) from diffusing into the semiconductor layer (6) through the side surface of the laminated structure.

2. The electrode of the semiconductor device of claim 1 wherein:
said laminated structure includes a layer (3) comprising Au and having a side surface as the specific layer except said lowermost layer;
said side barrier layer comprises a conductive material which can prevent the diffusion of Au from the layer (3) comprising Au into said semiconductor layer (6) through the side surface of the laminated structure; and
said side barrier layer is disposed at least on a region including the side surface of the layer (3) comprising Au.

3. The electrode of the semiconductor device of claim 2 including:
an intermediate barrier layer constituting said laminated structure and comprising a conductive material which can prevent the diffusion of Au from said layer (3) comprising Au into said semiconductor layer (6); and
said intermediate barrier layer being disposed below the layer (3) comprising Au and above said lowermost layer.

4. The electrode of the semiconductor device of claim 3 wherein:
said intermediate barrier layer comprises the same material as said side barrier layer and those layers are formed as a continuous layer; and
said side barrier layer is disposed on the side surface of said laminated structure above the intermediate barrier layer.

5. The electrode of the semiconductor device of claim 4 (Fig. 1) including a side covering layer comprising the same material as said lowermost layer and formed as a continuous layer with the lowermost layer on the surface of said side barrier layer.

6. The electrode of the semiconductor device of claim 2 wherein said lowermost layer comprises a material selected from a group consisting of Ti, WSiₓ, and WSiₓN_{y}.

7. The electrode of the semiconductor device of claim 3 wherein said lowermost layer comprises a material selected from a group consisting of Ti, WSiₓ, and WSiₓN_{y}.

8. The electrode of the semiconductor device of claim 4 wherein said lowermost layer comprises a material selected from a group consisting of Ti, WSiₓ, and WSiₓN_{y}.

9. The electrode of the semiconductor device of claim 5 wherein said lowermost layer comprises a material selected from a group consisting of Ti, WSiₓ, and WSiₓN_{y}.

10. The electrode of the semiconductor device of claim 2 wherein said side barrier layer comprises a material selected from a group consisting of Pt, Mo, TiNₓ, W, WSiₓ, and WSiₓN_{y}.

11. The electrode of the semiconductor device of claim 3 wherein said side barrier layer comprises a material selected from a group consisting of Pt, Mo, TiNₓ, W, WSiₓ, and WSiₓN_{y}.

12. The electrode of the semiconductor device of claim 3 wherein said intermediate barrier layer comprises a material selected from a group consisting of Pt, Mo, TiNₓ, W, WSiₓ and WSiₓN_{y}.

13. The electrode of the semiconductor device of claim 4 wherein said intermediate barrier layer comprises a material selected from a group consisting of Pt, Mo, TiNₓ, W, WSiₓ and WSiₓN_{y}.

14. The electrode of the semiconductor device of claim 5 wherein said intermediate barrier layer comprises a material selected from a group consisting of Pt, Mo, TiNₓ, W, WSiₓ and WSiₓN_{y}.

15. The electrode of the semiconductor device of claim 2 (Fig. 13) wherein:
said lowermost layer comprises a conductive material which can prevent Au from diffusing from said layer (3) comprising Au into said semiconductor layer (6); and
said side barrier layer comprises the same material as the lowermost layer and those layers are formed as a continuous layer.

16. The electrode of the semiconductor device of claim 15 (Fig. 13) wherein said lowermost layer and said side barrier layer (41) comprise a material selected from a group consisting of WSiₓ and WSiₓN_{y}.

17. A fabricating method of an electrode of a semiconductor device (Figs. 2(a)-2(e)) including:
preparing a semiconductor layer (6);
forming a groove (9) in a portion of the semiconductor layer (6) where an electrode is to be produced by dry etching;
depositing a first film comprising a conductive material over the side surface and the bottom surface in the groove (9) to form a side covering layer and a lowermost layer of a laminated structure;
depositing a second film comprising a conductive material which can prevent the diffusion of Au over the surfaces of the side covering layer and the lowermost layer to form a side barrier layer and an intermediate barrier layer of a laminated structure;
depositing an upper film comprising Au of a low resistance metal over the surfaces of the side barrier layer and the intermediate barrier layer so that it is embedded in the groove (9), thereby to form an upper layer portion (3) of a laminated structure; and
forming a recess (5) by etching a prescribed portion of the semiconductor layer (6) adjacent to the side surface of the groove (9), thereby forming an electrode that includes a laminated structure in the recess (5) successively laminating the lowermost layer (1), the intermediate barrier layer (2), and the upper layer portion (3), and the side barrier layer (2) and the side covering layer (1) which are formed over the side surface of the laminated structure.

18. A fabricating method of an electrode of a semiconductor device (Figs. 6(a)-6(e)) including:
preparing a semiconductor layer (6);
forming a groove (9) in a portion of the semiconductor layer (6) where an electrode is to be produced by dry etching;
depositing a first film comprising a conductive material only over the bottom surface in the groove (9) to form a lowermost layer (1) of a laminated structure;
depositing a second film comprising a conductive material which can prevent the diffusion of Au over the side surface of the groove (9) and the surface of the lowermost layer to form a side barrier layer and an intermediate barrier layer of a laminated structure;
depositing an upper film comprising Au of a low resistance metal over the surfaces of the side barrier layer and the intermediate barrier layer so that it is embedded in the groove (9), thereby to form an upper layer portion (3) of a laminated structure; and
forming a recess (5) by etching a prescribed portion of the semiconductor layer (6) adjacent to the side surface of the groove (9), thereby forming an electrode that includes a laminated structure in the recess (5) successively laminating the lowermost layer (1), the intermediate barrier layer (2), and the upper layer portion (3), and the side barrier layer (2) which is formed on the side surface of the laminated structure.

19. The fabricating method of the electrode of the semiconductor device of claim 17 wherein the deposition of said first and second films is carried out using sputtering technique.

20. The fabricating method of the electrode of the semiconductor device of claim 18 wherein the deposition of said first and second films is carried out using sputtering technique.

21. The fabricating method of the electrode of the semiconductor device of claim 17 wherein the deposition of said first and second films is carried out using oblique vacuum evaporation.

22. The fabricating method of the electrode of the semiconductor device of claim 18 wherein the deposition of said second film is carried out using oblique vacuum evaporation.

23. The fabricating method of the electrode of the semiconductor device of claim 17 wherein the deposition of said first and second films is carried out using CVD.

24. The fabricating method of the electrode of the semiconductor device of claim 18 wherein the deposition of said first and second films is carried out using CVD.

25. A fabricating method of an electrode of a semiconductor device (Figs. 4(a)-4(c)) including:
preparing a semiconductor layer (6);
forming a resist (11) on a region of the semiconductor layer (6) except a region where a recess is to be produced;
etching the portion of the semiconductor layer (6) using the resist (11) as a mask to form a recess (5);
successively depositing a first film comprising a conductive material and a second film comprising a conductive material which can prevent the diffusion of Au on the bottom surface of the recess (5) by performing oblique vacuum evaporation using the resist (11) as a mask so that the films have a concavity in its cross-section configuration, thereby to form a lowermost layer and a side covering layer of a laminated structure each comprising the first film and an intermediate barrier layer and a side barrier layer of a laminated structure each comprising the second film; and
depositing an upper film comprising Au of a low resistance metal over the inner surfaces of the side barrier layer and the intermediate barrier layer having the concavity using the resist (11) as a mask so that it is embedded in the concavity, thereby to form an upper layer portion (3) of a laminated structure, thereby forming an electrode that includes a laminated structure successively laminating the lowermost layer (1), the intermediate barrier layer (2), and the upper layer portion (3), and the side barrier layer (2) and the side covering layer (1) which are formed on the side surface of the laminated structure.

26. A fabricating method of an electrode of a semiconductor device (Figs. 8(a)-8(d)) including:
preparing a semiconductor layer (6);
forming a resist (11) on a region of the semiconductor layer (6) except a region where a recess is to be produced;
etching the portion of the semiconductor layer (6) using the resist (11) as a mask to form a recess (5);
depositing a first film comprising a conductive material on the bottom surface of the recess (5) using the resist (11) as a mask to form a lowermost layer (1) of a laminated structure;
depositing a second film comprising a conductive material which can prevent the diffusion of Au on the lowermost layer (1) by performing oblique vacuum evaporation using the resist (11) as a mask so that the second film has a concavity in its cross-section configuration, thereby to form an intermediate barrier layer of a laminated structure and a side barrier layer; and
depositing an upper film comprising Au of a low resistance metal over the inner surface of the side barrier layer and the intermediate barrier layer having the concavity using the resist (11) as a mask so that it is embedded in the concavity, thereby to form an upper layer portion (3) of a laminated structure, thereby forming an electrode that includes a laminated structure successively laminating the lowermost layer (1), the intermediate barrier layer (2), and the upper layer portion (3) and the side barrier layer (2) which is formed on the side surface of the laminated structure.

27. A fabricating method of an electrode of a semiconductor device (Figs. 10(a)-10(c)) including:
preparing a semiconductor layer (6);
successively depositing a first film comprising a conductive material on a region of the semiconductor layer (6) where an electrode is to be produced, a second film comprising a conductive material which can prevent the diffusion of Au, and an upper film comprising Au of a low resistance metal to form a laminated structure laminating a lowermost layer (1) comprising the first film, an intermediate barrier layer (2) comprising the second film, and an upper layer portion (3) comprising the upper film;
forming an insulating film (20) on a region of the semiconductor layer (6) except the region where the laminated structure is formed to expose at least the entire side surface of the upper layer portion (3) of the laminated structure over the surface of the insulating film (20);
depositing a barrier film comprising a conductive material which can prevent the diffusion of Au over the entire surface of the insulating film (20) and the laminated structure including the exposed side surface;
forming a resist (28) on the barrier film covering the laminated structure and selectively etching the barrier film using the resist (28) as a mask to form a side barrier layer (22) comprising the barrier film over the front surface and the side surface of the upper layer portion (3) of the laminated structure; and
removing the resist (28) to form an electrode including the laminated structure and the side barrier layer (22).

28. A fabricating method of an electrode of a semiconductor device (Figs. 12(a) and 12(b)) including:
preparing a semiconductor layer (6);
successively depositing a first film comprising a conductive material on a region of the semiconductor layer (6) where an electrode is to be produced, a second film comprising a conductive material which can prevent the diffusion of Au, and an upper film comprising Au of a low resistance metal to form a laminated structure laminating a lowermost layer (1) comprising the first film, an intermediate barrier layer (2) comprising the second film, and an upper layer portion (3) comprising the upper film;
forming an insulating film (20) on a region of the semiconductor layer (6) except the region where the laminated structure is formed to expose at least the entire side surface of the upper layer portion (3) of the laminated structure over the surface of the insulating film (20);
depositing a barrier film comprising a conductive material which can prevent the diffusion of Au over the entire surface of the insulating film (20) and the laminated structure including the exposed side surface of the laminated structure; and
performing an anisotropic etching to the barrier film to remove the barrier film except the portion covering the side surface of the upper layer portion (3) of the laminated structure, thereby forming an electrode that includes the laminated structure and a side barrier layer (32) comprising the barrier film which is left on the side surface of the upper layer portion (3).

29. A fabricating method of an electrode of a semiconductor device (Figs. 14(a) and 14(b)) including:
preparing a semiconductor layer (6);
forming a groove (9) in a portion of the semiconductor layer (6) where an electrode is to be produced by dry etching;
depositing a film comprising a conductive material which can prevent the diffusion of Au over the side surface and the bottom surface in the groove (9) to form a side barrier layer and a lowermost layer of a laminated structure;
depositing an upper film comprising Au of a low resistance metal over the surfaces of the side barrier layer and the lowermost layer so that it is embedded in the groove (9), thereby to form an upper layer portion (3) of a laminated structure; and
forming a recess (5) by etching a prescribed portion of the semiconductor layer (6) adjacent to the side surface of the groove (9), thereby forming an electrode (4) that includes a laminated structure in the recess (5) laminating the lowermost layer (41) and the upper layer portion (3), and the side barrier layer (41) which is formed on the side surface of the laminated structure.

30. The fabricating method of the electrode of the semiconductor device of claim 17 (Fig. 3) including:
an etching stopper layer (62) provided in said semiconductor layer (6); and
the etching of the semiconductor layer (6) for forming said groove (9) and for removing a prescribed portion of the semiconductor layer (6) adjacent to the side surface in the groove (9) after the formation of all layers constituting the electrode (4) in the groove (9) being stopped automatically when the etching stopper layer (62) is exposed.

31. The fabricating method of the electrode of the semiconductor device of claim 18 (Fig. 7) including:
an etching stopper layer (62) provided in said semiconductor layer (6); and
the etching of the semiconductor layer (6) for forming said groove (9) and for removing a prescribed portion of the semiconductor layer (6) adjacent to the side surface in the groove (9) after the formation of all layers constituting the electrode (4) in the groove (9) being stopped automatically when the etching stopper layer (62) is exposed.

32. The fabricating method of the electrode of the semiconductor device of claim 29 including:
an etching stopper layer (62) provided in said semiconductor layer (6); and
the etching of the semiconductor layer (6) for forming said groove (9) and for removing a prescribed portion of the semiconductor layer (6) adjacent to the side surface in the groove (9) after the formation of all layers constituting the electrode (4) in the groove (9) being stopped automatically when the etching stopper layer (62) is exposed.

33. The fabricating method of the electrode of the semiconductor device of claim 30 wherein said etching stopper layer (62) comprises AlGaAs.

34. The fabricating method of the electrode of the semiconductor device of claim 31 wherein said etching stopper layer (62) comprises AlGaAs.

35. The fabricating method of the electrode of the semiconductor device of claim 32 wherein said etching stopper layer (62) comprises AlGaAs.
